# EUROPEAN PATENT APPLICATION

(11) **EP 0 731 507 A1**
(43) Date of publication of application: **11.09.1996**
(21) Application number: 96301625.8
(22) Date of filing: 08.03.1996
(51) Int. Cl.: H01L 29/49, G02F 1/136

(54) **Electrode materials**

(30) Priority: 08.03.1995 JP 48861/95; 08.03.1995 JP 48896/95; 18.08.1995 JP 210560/95
(71) Applicant: International Business Machines Corporation, Armonk, N.Y. 10504 (US)
(72) Inventor: Takayama, Shinji, Mitaka-shi, Tokyo-to (JP)
(74) Representative: Lloyd, Richard Graham

(57) **Abstract**

Conductor line materials are described substantially comprising Al and characterised in that the materials comprise at least one element selected from a group consisting of rare-earth elements, the total quantity of said rare-earth elements being less than 3.0 atomic percent, and in that said conductor line materials are formed by heat-treatment at a temperature between 250 and 450°C.

## Description

The present invention relates to electrode conductor line materials for electronic devices such as liquid crystal display devices.

Pure metals such as Cu, Al, Mo, Ta, and W, or alloy materials such as Al-Cu, Al-Cu-Si, and Al-Pd have been used in electronic devices as electrode conductor line materials having low electric resistance. However, in electrode conductor line materials for the liquid crystal display devices which have recently attracted public attention as thin display devices, excellent properties different from those of conventional materials are required, such as suitability for large area conductor lines for large screens and highly dense conductor lines for high resolution, and the possibility of array fabrication by a high temperature process.

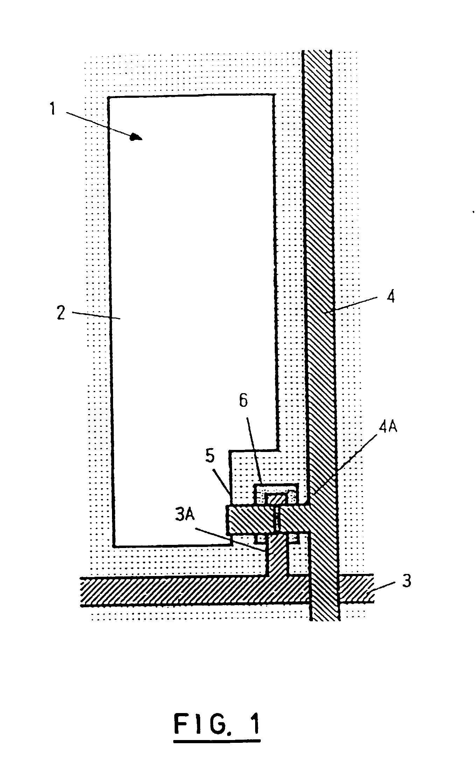

Figure 1 shows a schematic diagram of a pixel in the array of a thin film transistor (TFT) liquid crystal display device. A pixel opening 1 is provided with a display electrode 2, a gate line 3, a gate electrode 3A, a data line 4, a drain electrode 4A, a source electrode 5, and a TFT active element 6. When the TFT is turned on by the signal on the gate line 3, the potential of the data line 4 becomes equal to the potential of the pixel electrode 2 connected through the source electrode 5. As the result, liquid crystals contained in the upper part of the pixel electrode 2 are oriented making the pixel be in the display condition. Here, an array electrode conductor line material of a liquid crystal display device of the type with which the present invention is concerned is used in the gate line 3, the gate electrode 3A, the data line 4, the drain electrode 4A, and the source electrode 5.

The properties required in electrode conductor line materials for liquid crystal display devices include a low electric resistance. A high electric resistance causes various problems such as the delay of signals and the generation of heat, especially in manufacturing large liquid crystal display devices. For this reason, pure Al, which has a low electric resistance, has been used as the conductor line material for liquid crystal display devices. Pure Al excels in etching characteristics, and is a suitable material from the point of view of adhesion with the substrate. However, pure Al has the disadvantage that it has a low melting point, and is prone to defects known as hillocks during the heating step in the CVD process after the formation of the conductor line film. This heating step is normally performed at a temperature of about 400°C, and when the conductor line material is observed after this step, defects such as small projections and pinholes may be found. Such small projections are called hillocks and if these occur, the flatness of the conductor line material layer is lost, and oxidized films cannot be formed on the conductor line material layer in subsequent steps. The occurrence of hillocks is a great problem in the manufacture of liquid display devices. Although the mechanism of the occurrence of hillocks has been unknown, it is considered that hillocks occur when a stress in the compression direction is applied to the thin film by heating due to difference in the coefficient of linear expansion between the thin film and the substrate, and Al atoms are driven by this stress and move along grain boundaries.

The occurrence of hillocks may be prevented by using refractory materials such as Cr, Ti, Ta, and MoTa, because the diffusion of atoms along grain boundaries is unlikely to occur. However, all of these refractory materials have as high specific resistance as 50 µΩ·cm (about 4 µΩ·cm for Al), and their electrical properties are not desirable for conductor line materials. Consequently, these high resistance materials are not suitable for manufacturing large liquid crystal display devices.

Therefore, the development of Al-based alloy electrode conductor line materials has been tried. Although Al-Cu and Al-Cu-Si alloys were reported in the past, and Al-Ta and Al-Zr alloys were reported recently, these were not satisfactory in both the occurrence of hillocks at a high temperature of 300°C or above, and high electric resistance.

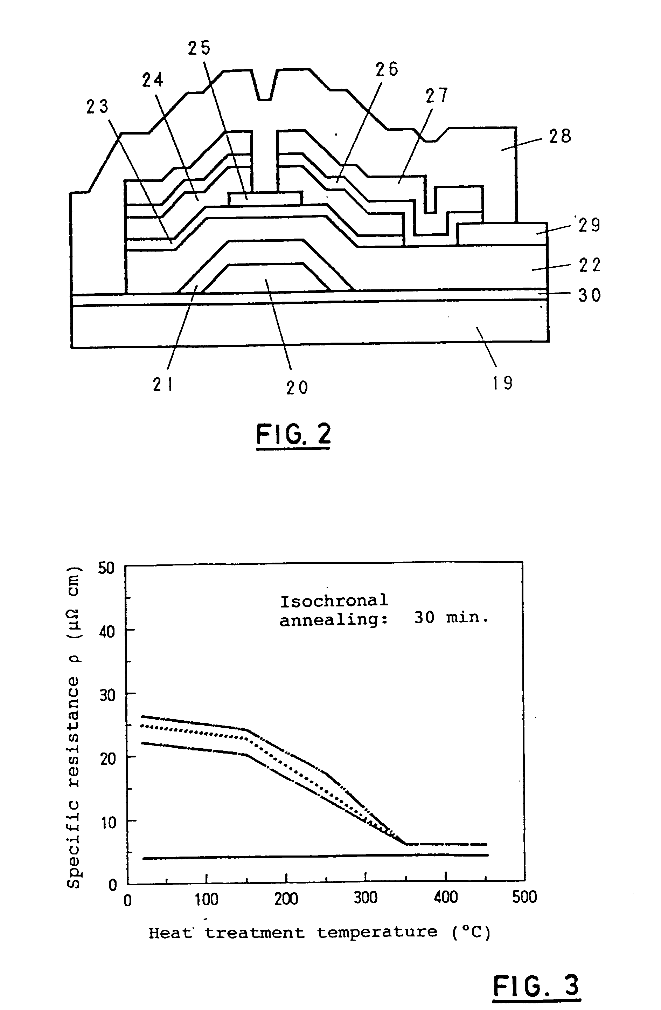

Figure 2 shows a cross-sectional view of a liquid-crystal display. In order to prevent a dielectric breakdown while the TFT is on, gate insulating film 22 is formed to insulate a glass substrate 19 and a conductor line material layer 20 formed on an undercoat layer 30 on the glass substrate 19 from a transparent electrode 29, a amorphous silicon layer 23, and source/drain electrodes 27. The gate insulating film 22 consists of silicon oxide or silicon nitride and is laminated on the conductor line material layer 20. A ohmic layer 24 and a channel protective film 25 are formed on the amorphous silicon layer 23, and a molybdenum layer 26 is formed between the ohmic layer 24 and the source/drain electrodes 27. A protective film 28 is formed to protect the entire set of layers. The protective film 28 is made of silicon nitride.

Thus, a liquid crystal display comprises many layers of oxides and nitrides. The formation of these layers involves complex production processes. In addition, any defect in a formed layer can cause a dielectric breakdown. Particularly, the formation of silicon oxide film 21 for insulation of the conductor line material layer 20 entails a process in which an oxide film is formed by a normal-pressure CVD process to eliminate pin-holes then another oxide film is formed by a reduced-pressure CVD process.

In order to reduce the complexity of the process to form the insulating film and to solve the dielectric breakdown problem, it is desirable that the electrode conductor material used for the gate electrode can be directly oxidized by anodic oxidization to form a dense oxide film which substitutes the above-mentioned insulating film. According to this method, the insulating film, which is conventionally formed in several processes, can be formed in one process. In addition, the anodic oxidation is suitable to form a dense oxide film These advantages can be achieved by using pure Al as conductor material. However, as described above, pure Al has the disadvantage that it causes hillocks.

It is an object of the present invention to provide an electrode conductor line material, in particular an electrode conductor line material used in liquid crystal display devices, which has high thermal stability, fewer occurrence of defects such as hillocks, low electric resistance, and which forms a dense insulation film easily by anodic oxidation.

According to the invention there is provided a conductor line material substantially comprising Al and characterised in that the material comprises at least one element selected from a group consisting of rare-earth elements, the total quantity of said rare-earth elements being less than 3.0 atomic percent, and in that said conductor line material is formed by heat-treatment at a temperature between 250 and 450°C.

In a first embodiment, this is achieved by precipitating in a matrix an intermetallic compound of Al and a rare-earth element via the heat treatment of an alloy whose composition formula is substantially expressed by Alₓ(M_{y}N_{1-y})₁₋ₓ, where M represents at least one element selected from a group consisting of rare-earth element, N represents at least one element selected from a group consisting of Nb, Zr, and Ta, x is between 98 and 99.5 atomic percent, and y is preferably a number between 0.1 and 0.9.

In the present invention, the above properties are achieved by adding an additive element to Al. In general, the electric resistance of Al increases significantly when an additive element is added. This tendency is high when the additive element forms a solid solution in Al. Therefore, an element that improves heat stability and prevents defects such as hillocks by the addition of a trace amount was sought, and the resulting decrease in electric resistance was measured after precipitating an intermetallic compound of Al by the heat treatment of the solute additive element in a state of solid solution.

Specifically, it was found to give good results to add rare-earth elements such as Y, La, Pr, Nd, Gd, Dy, Ho, Er, a part of which is then substituted in a preferred embodiment by a refractory metal element such as Nb, Zr, and Ta. At least one of each of these rare-earth elements and refractory metal elements was added to Al in a total amount of 0.5 - 2.0 atomic percent, and solute atoms were precipitated as an intermetallic compound with Al by heat treatment in the range between 300 and 450°C. In this way, an improved conductor line material for liquid crystal display devices which has fewer defects such as hillocks and pinholes, and extremely low electric resistance was obtained. According to the present invention, as described above, the heat treatment of the conductor line material is essential. This is because the solute atoms dissolved in the matrix are precipitated in the matrix in the form of an intermetallic compound with Al, electric resistance is decreased by decreasing the concentration of atoms dissolved in the matrix; and the precipitated intermetallic compound prevents defects such as hillocks from occurring by restricting the movement of atoms at high temperatures. It is therefore important that the intermetallic compound is precipitated in the matrix, and the temperature of heat treatment is merely a guideline. Therefore, although the desired object is achieved by heat treatment at a temperature up to 500°C, which is higher than the temperature described above, further higher temperatures are not desirable because such temperatures will cause the production of coarse particles, the occurrence of excessive thermal stress in the conductor line material, and the occurrence of defects such as hillocks.

As a result, the conductor line material obtained has few defects such as hillocks at as high temperature as 350°C or more, and the electric resistance is 4 - 6 µΩ·cm which is equivalent to or about twice that of pure Cu. For electric resistance, since the best of conventional conductor line materials with little occurrence of hillocks has a resistance of about 8 µΩ·cm which is almost three times as high as that of pure Al (Al-Ta system), the conductor line material of the present invention has much better properties than conventional known materials.

The occurrence of hillocks may be prevented even by materials to which no refractory metal element is added. However, if no refractory metal element is added, oxidation resistance is poor, and corrosion resistance is also low. Therefore, the addition of an element such as Nb, Zr, and Ta is preferred.

Furthermore, the inventors have discovered that the addition of these elements increases significantly the breakdown voltage of the formed anodically oxidized film. That is, the addition of a refractory metal element is considered to densify the anodically oxidized film, and improve its dielectric breakdown characteristics. It is therefore possible that the process for manufacturing liquid crystal display devices, which formed multiple layers of insulation films after wiring, is shortened by anodically oxidizing the conductor line material thus obtained. It was also found that corrosion resistance was improved by adding these elements. It was further found that corrosion resistance and oxidation resistance were improved by adding a well-balanced amount of these elements while maintaining desirable properties of the alloy to which rare-earth elements were added, such as the occurrence of hillocks and electric resistance.

The composition of the conductor line material according to the present invention may also be described as the composition whose composition formula is expressed by AlₓL₁₋ₓ (where M represents at least one element selected from a group consisting of rare-earth elements, and x is between 98 and 99.5 atomic percent), a part of the rare-earth elements is substituted by at least one selected from a group consisting of Nb, Zr, and Ta.

In other embodiments, the object of the invention is achieved by precipitating in a matrix an intermetallic compound of Al and at least one of rare-earth elements selected from a group consisting of Y, La, Nd Gd, and Dy, and precipitating an intermetallic compound of Al and the rare-earth elements by subsequent heat treatment.

This is also achieved in further embodiments by depositing in a matrix an intermetallic compound of Al and a rare-earth element formed by the heat treatment of an alloy of Al containing 0.5 - 3.0 atomic percent of at least one of rare-earth elements selected from a group consisting Pr, Sm, Ho, and Er. The temperature of heat treatment in both cases is preferably in the range between 250 and 450°C, and the electric resistance is 10 µΩ·cm or below, and in the preferred embodiment, about 5 µΩ·cm. The mixing of impurities unavoidable in metallurgy is not beyond the scope of the present invention.

A portion of a conductor line material substantially comprising Al containing 0.1 - 3.0 atomic percent of at least one of rare-earth elements selected from a group consisting of Y, La, Pr, Nd, Sm, Gd, Dy, Ho, and Er can be anodically oxidised. The resulting metal conductor line layer should be heat-treated to precipitate an intermetallic compound of Al and the rare-earth elements in a matrix, so that the electric resistance of the layer is adjusted to 10 µΩ·cm or below. It is desirable that the thickness of the anodic oxide film is 100 - 400 nm.

Specifically, it was also found to give good results to add rare-earth metal elements such as Y, La, Pr, Nd, Gd, Dy, Ho and Er. At least one of these metal elements in an amount of 0.1 - 3.0 atomic percent, and solute atoms were precipitated as an intermetallic compound with Al by heat treatment in the range between 250 and 450°C. In this way, a conductor line material for liquid crystal display devices, which has low electric resistance and fewer defects such as hillocks and pinholes is obtained. The amount of these atoms is in an allowable range up to a maximum of 3.0 atomic percent from the point of view of electric resistance. If a larger amount of the elements are added, heat treatment must be performed at a higher temperature or for a longer time. According to the present invention, as described above, the heat treatment of the conductor line material is essential. This is because the atoms of the rare-earth elements dissolved in the matrix are precipitated in the matrix in the form of an intermetallic compound with Al, electric resistance is decreased by decreasing the concentration of atoms dissolved in the matrix, and the precipitated intermetallic compound prevents defects such as hillocks from occurring by restricting the movement of atoms at high temperatures. It is therefore important that the intermetallic compound is precipitated in the matrix, and the temperature of heat treatment is merely a guideline. Therefore, although the desired object is achieved by heat treatment at a temperature up to 500°C, which is higher than the temperature described above, further higher temperatures are not desirable because such temperatures will cause the production of coarse particles, the occurrence of excessive thermal stress in the conductor line material, and the occurrence of defects such as hillocks.

The optimum amount of the atoms differs depending on atoms added. For example, for La, Nd, Gd, and Dy among the elements described above, the conductor line material with the best balance of electric resistance and heat resistance was obtained when 0.5 - 1.0 atomic percent of the elements were added. For Pr, Sm, Ho and Er, on the other hand, the best-balanced conductor line material was obtained when 0.5 - 2.0 atomic percent of the elements were added. As the result, the conductor line material obtained has fewer defects such as hillocks at as high temperatures as 350°C or more, and the electric resistance is 4 - 6 µΩ·cm which is equivalent to or about twice that of pure Al. For electric resistance, since the best of conventional conductor line materials with fewer hillocks has a resistance of about 8 µΩ·cm which is almost three times as high as that of pure Al (Al-Ta system), the conductor line material of the present invention has much better properties than conventional known materials.

A conductor line layer which has high dielectric strength and an excellent insulating characteristic can be formed by anodically oxidizing the conductor line layer. Elements which should be added in this embodiment are Y, La, Pr, Nd, Gd, and Dy. The desired object is achieved by adding at least one of these elements in an amount of 0.5 to 3.0 atomic percent to the conductor line layer, anodically oxidizing its surface to form an insulating layer, then heat-treating it at a temperature between 300 and 450°C to deposit an intermetallic compound. It was found that the resulting insulating film has a dielectric strength of 7.5 MV/cm or more, which is that of pure Al, and is a good insulating film with little occurrence of defects.

Using such anodically oxidized conductor line layer of Al - rare-earths compound for a liquid-crystal display TFT array reduces the width of an electrode conductor line to 5 µm or less, providing 60% or more pixel opening degrees. In addition, such layer minimizes signal delay and has good characteristics suitable for larger displays with higher definition. It is desirable that the thickness of the anodic oxide film is at least 100 nm, because the thicker the film the higher the dielectric strength. However, increasing the film thickness increases the internal stress and which may cause dielectric breakdown, therefore, the thickness should be 400 nm or less.

The object of the present invention is also achieved by depositing in a matrix an intermetallic compound of Al and a rare-earth element formed by the heat treatment of an alloy of Al containing 0.5 - 2.0 atomic percent of Nb. The temperature of heat treatment in both cases is preferably in the range between 250 and 450°C, and the electric resistance is 10 µΩ·cm or below, and in the preferred embodiment, about 5 µΩ·cm. The mixing of impurities unavoidable in metallurgy is not beyond the scope of the present invention.

The inventors have also studied if the same effect is obtained without adding rare-earth elements. The results showed that an alloy which has a low electric resistance and a low possibility of the occurrence of hillocks, and may form a strong insulation film by anodic oxidation may be formed from the Al-Nb alloy system. The amount of Nb added is between 0.5 and 2.0 atomic percent, and as in the ternary alloys to which rare-earth elements are added, heat treatment if performed at a temperature of 250°C or above. The detail of these method is shown below together with experimental data.

In the drawings:
Figure 1 shows a top view of a pixel portion of a liquid crystal display device;
Figure 2 shows a sectional view of a pixel portion of a liquid crystal display device;
Figure 3 shows a graph illustrating relationship between heat treatment temperature and specific resistance of an embodiment of the present invention when heat treatment time is constant 30 min;
Figure 4 shows an X-ray diffraction profile of an embodiment of the present invention heat-treated at 350°C;
Figure 5 shows a graph illustrating relationship between heat treatment temperature and specific resistance of an embodiment when heat treatment temperature is constant;
Figure 6 shows a graph illustrating relationship between heat treatment temperature and specific resistance of an embodiment when heat treatment time is constant;
Figure 7 shows a X-ray diffraction profile illustrating relationship between heat treatment temperature and the deposition of the intermetallic compound of an embodiment of the present invention;
Figure 8 shows a X-ray diffraction profile illustrating relationship between heat treatment temperature and the deposition of the intermetallic compound of another embodiment of the present invention;
Figure 9 shows a graph illustrating relationship between heat treatment temperature and specific resistance of another embodiment of the present invention when heat treatment time is constant; and
Figure 10 shows a graph illustrating relationship between heat treatment temperature and specific resistance of another embodiment of the present invention when heat treatment time is constant 30 min.

### Example 1

An Al alloy thin film of a thickness of about 300 nm was formed by vapour deposition or sputtering using a composite target of an alloy produced by mixing at least one element selected from a group consisting of Y, Nd, and Gd, and at least one element selected from a group consisting of Zr, Nb, and Ta with Al, or a composite target comprising the chip of the above elements formed on an Al plate. Table 1 shows the specific resistance and the number of hillocks of Al alloy films heat-treated in vacuum at 350°C for one hour, and the breakdown voltage of films formed by anodically oxidizing the alloy films. For comparison, the results are shown of thin films consisting of Al element alone and alloy films consisting of Al and additive elements in a total amount more than 2 atomic percent and less than 0.5 atomic percent.

**TABLE 1**

| **Composition** | **Specific resistance (µΩ·cm)** | **Occurrence of hillocks** | **Breakdown voltage (MV/cm)** |
|---|---|---|---|
| Comparative example | | | |
| Al | 3.6 | many | 7.8 |

| Example | | | |
|---|---|---|---|
| Al99 (Nd0.7Zr0.3)1 | 5.6 | none | 7.5 |
| Al98(Nd0.5Ta0.5)2 | 6.2 | little | 7.0 |
| Al98.5(Nd0.4Nb0.6)1.5 | 5.7 | none | 7.7 |
| Al98.7(Y0.7Nb0.3)1.3 | 6.1 | none | 6.9 |
| Al99(Y0.5Zr0.5)1 | 5.6 | none | 7.6 |
| Al98.2(Y0.4Ta0.6)0.8 | 5.5 | none | 7.4 |
| Al98(Gd0.7Ta0.3)2 | 6.0 | none | 7.0 |
| Al99(Gd0.5Nb0.5)1 | 5.4 | none | 7.0 |
| Al98.5(Gd0.4Zr0.6)1.5 | 5.8 | none | 7.6 |

| Comparative example | | | |
|---|---|---|---|
| Al97(Nd0.7Ta0.3)3 | 15.0 | none | 6.5 |
| Al99.6(Nd0.7Ta0.3)0.4 | 6.0 | many | 7.5 |
| Al99.8(Y0.7Zr0.3)0.2 | 5.0 | many | 7.5 |
| Al97.5(Gd0.5Nb0.5)2.5 | 18.0 | none | 6.5 |

As Table 1 shows, the Al alloy thin film of the present invention has a high heat stability, few defects, high reliability, and an extremely low resistance, and is most suitable for the TFT electrode conductor line material for liquid crystal display devices. As shown in Table 1, in the alloy having the composition formula of Alₓ(M_{y}N_{1-y})₁₋ₓ, good results are obtained when x is between 0.5 and 2 atomic percent. If x is smaller than this range, the occurrence of hillocks increases, and if x is larger than this range, electric resistance increases. Large change in breakdown voltage is not observed within a wide range of composition, and in preferred embodiments, breakdown voltage decreases by 15 percent or less from the breakdown voltage of pure Al. If the amount of additive elements is increased to x = 2.5, the thin film tends to deteriorate.

The ratio of a rare-earth element M and a refractory metal element N gives good properties in a wide range. When the amount of the rare-earth element is larger or the amount of the refractory metal element is larger, good properties may be obtained if x is within the above described range. However, it has been known that the rare-earth element alone does not provide favourable anodic oxidation and good corrosion resistance, and an extremely small amount of the refractory metal element may cause problems. In contrast, if the amount of the rare-earth element is extremely small, there is possibility not to cause serious problems when the fact is considered that the Al-Nb binary system exhibits good properties as Example 5 shows. Although only Y, Nd, and Gd are shown as rare-earth elements, the same effects are expected by other rare-earth elements such as La, Pr, Sm, Dy, Ho, and Er. Rare-earth elements, especially a group of elements belonging to the lanthanide group have the same number of electrons in outermost and second outermost shells, and their chemical characteristics are similar to each other. In fact, it has been confirmed that the binary system with Al has the same effect on the prevention of hillocks. (See Examples 2, 3 and 4).

Figure 3 shows relationship between heat treatment temperature and electric resistance of typical alloys of the present invention. The uppermost curve is of Al₉₉(Nd_{0.7}Zr_{0.3})₁, the second is of Al_{98.2}(Y_{0.4}Ta_{0.6})_{1.8}, the third is of Al₉₉(Gd_{0.5}Nb_{0.5})₁, and the lowermost curve is of pure Al. The marked decrease in electric resistance is seen with increase in heat treatment temperature. It is therefore required to perform heat treatment at a temperature of 250°C or above, and preferably between 300 and 400°C. Excessively high heat treatment temperature, e.g., 500°C is not desired because such a high temperature may increase the occurrence of hillocks and cause coarse particles to form.

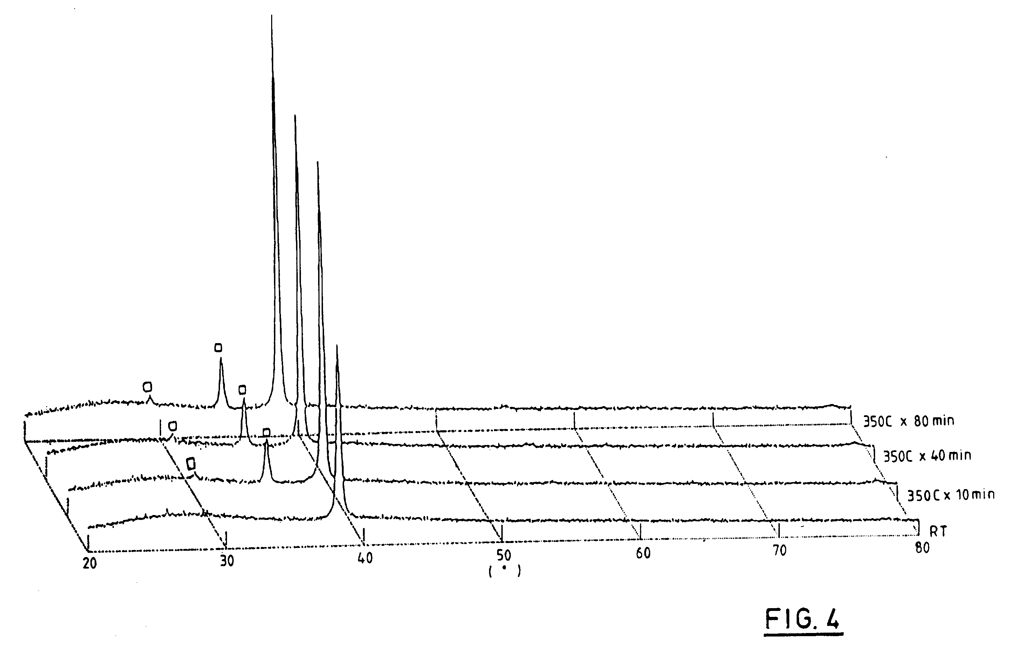

Figure 4 shows an X-ray diffraction chart of Al₉₉(Nd_{0.7}Zr_{0.3})₁, an embodiment of the present invention, heat-treated at 350°C. The appearance of peaks (□), which were not present before heat treatment, is considered to correspond to the precipitation of intermetallic compounds. The reason for such decrease in electric resistance due to heat treatment is that the solute atoms (rare-earth and refractory metal elements) dissolved in the matrix react with the base Al to form intermetallic compounds, resulting in a decrease in the number of solute atoms dissolved in the matrix. Refractory metals such as Nb and Zr are also elements which form intermetallic compounds with Al easily. It is thought that such microscopic internal change contributes to decrease in the occurrence of hillocks. It has been known that the occurrence of hillocks tends to decrease when an intermetallic compound of Al with any element is deposited. However, the addition of any known element does not decrease the occurrence of hillocks dramatically as the addition of rare-earth elements. In this aspect, the mechanism of hillock prevention is considered to result not only from the deposition of intermetallic compounds, but also by some unknown mechanism based on the inherent nature of rare-earth metal elements.

### Example 2

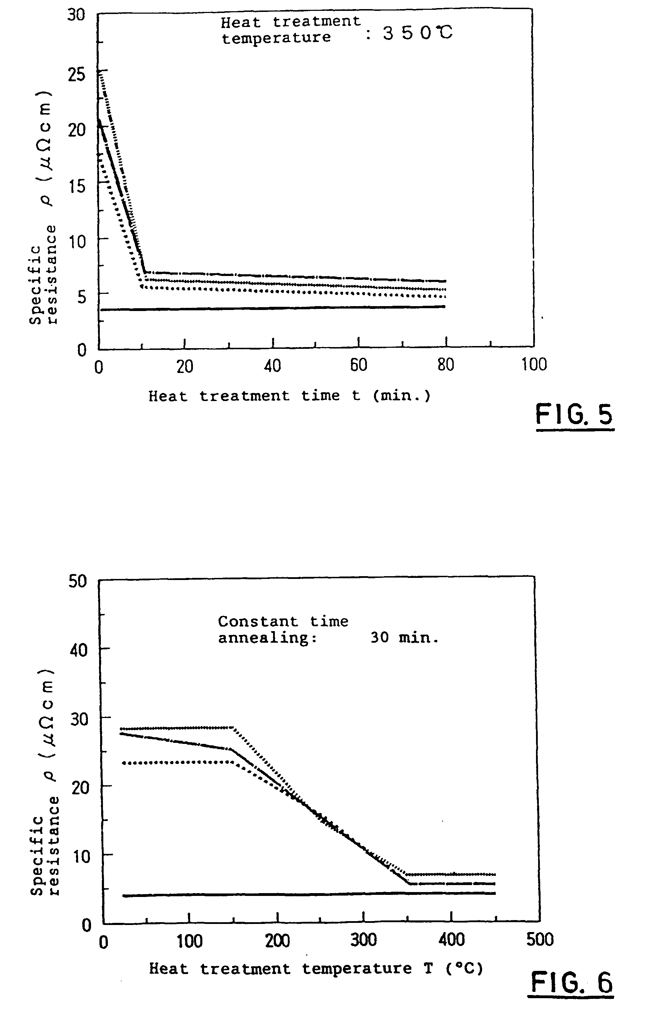

An Al alloy thin film of a thickness of about 300 nm was formed by vapour deposition or sputtering using a composite target of an alloy produced by mixing at least one element selected from a group consisting of Y, La, Nd, Gd, and Dy, or a composite target comprising the chip of the above elements formed on an Al plate. Table 2 shows the specific resistance and the number of hillocks of Al alloy film heat-treated in vacuum at 350°C for one hour. For comparison, the results are shown of typical thin films consisting of Al element alone and alloy films consisting of Al and additive elements in a total amount more than 3.0 atomic percent and less than 0.1 atomic percent. Changes in the specific resistance of AlY, AlLa, and AlNd alloy film during heat treatment in vacuum at a constant temperature of 350°C are shown in Figure 5, and changes in the specific resistance of AlGd, AlDy, and AlNd alloy films after annealing heat treatment at different temperatures for a constant time of 30 minutes are shown in Figure 6. In both Figure 5 and Figure 6, the uppermost curve represents Al₉₉Nd₁, followed by Al₉₉La₁ and Al₉₉Y₁, and the lowermost curve represents pure Al used for comparison.

**TABLE 2**

| | **Composition** | **Specific resistance (µΩ·cm)** | **Occurrence of hillocks** |
|---|---|---|---|
| Embodiment | Al99.5Gd0.5 | 5.0 | None |
| Embodiment | Al99.5Dy0.5 | 5.5 | None |
| Embodiment | Al99Gd1 | 5.4 | None |
| Embodiment | Al99Dy1 | 5.0 | None |
| Embodiment | Al99Y1 | 4.6 | None |
| Embodiment | Al99.2Y0.8 | 5.8 | None |
| Embodiment | Al99La1 | 5.7 | None |
| Embodiment | Al99.2La0.8 | 5.0 | None |
| Embodiment | Al99Nd1 | 5.2 | None |
| Embodiment | Al99.2Nd0.8 | 5.0 | None |
| Embodiment | Al97.7Y2.3 | 6.7 | None |
| Embodiment | Al97.9Nd2.1 | 6.8 | None |
| Embodiment | Al97.6Dy2.4 | 6.6 | None |
| Embodiment | A197Nd3 | 6.2 | None |
| Embodiment | A197.2La2.8 | 6.5 | None |
| Embodiment | Al97.5Y2.5 | 4.8 | None |
| Comparative Example | Al | 3.6 | Many |
| Comparative Example | Al99.95Gd0.05 | 4.5 | Many |
| Comparative Example | Al99.93Dy0.07 | 4.4 | Many |
| Comparative Example | A199.92Y0.08 | 4.5 | Many |
| Comparative Example | A196.5Y3.5 | 7.5 | None |
| Comparative Example | A196.5Nd3.5 | 7.5 | None |
| Comparative Example | A196.5L3.5 | 7.4 | None |

As Table 2 and Figures 5 and 6 show, the alloy thin film consisting of Al and rare-earth elements has a high heat stability, fewer defects, high reliability, and an extremely low resistance, and is most suitable for the TFT electrode conductor line material for liquid crystal display devices. As shown in Table 2, an excellent electrode material was obtained when the amount of the rare-earth elements is 3.0 atomic percent or less, preferably 1.4 atomic percent or less. If the amount is smaller than 0.1 atomic percent, the occurrence of hillocks increases significantly, and if the amount is larger than 3.0 atomic percent, electric resistance increases significantly. Large change is not observed if the time for heat treatment is 20 minutes or more, as shown in Figure 5. This is considered to be because the required precipitation of the intermetallic compound of Al and rare-earth elements is completed in the initial several minutes, and thereafter equilibrium at that temperature is reached. As Figure 6 shows, the effect of temperatures during annealing for 30 minutes is large. The electric resistance decreases by heat treatment at a temperature of 250°C or above, and an especially significant decrease in resistance is observed at a temperature of 300°C or above.

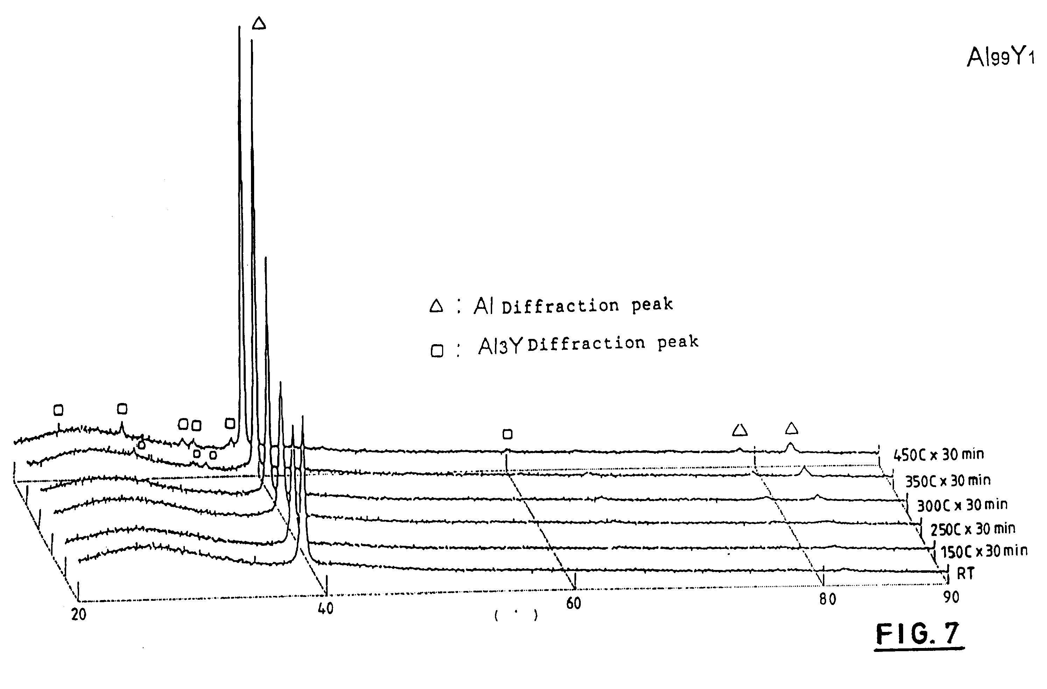

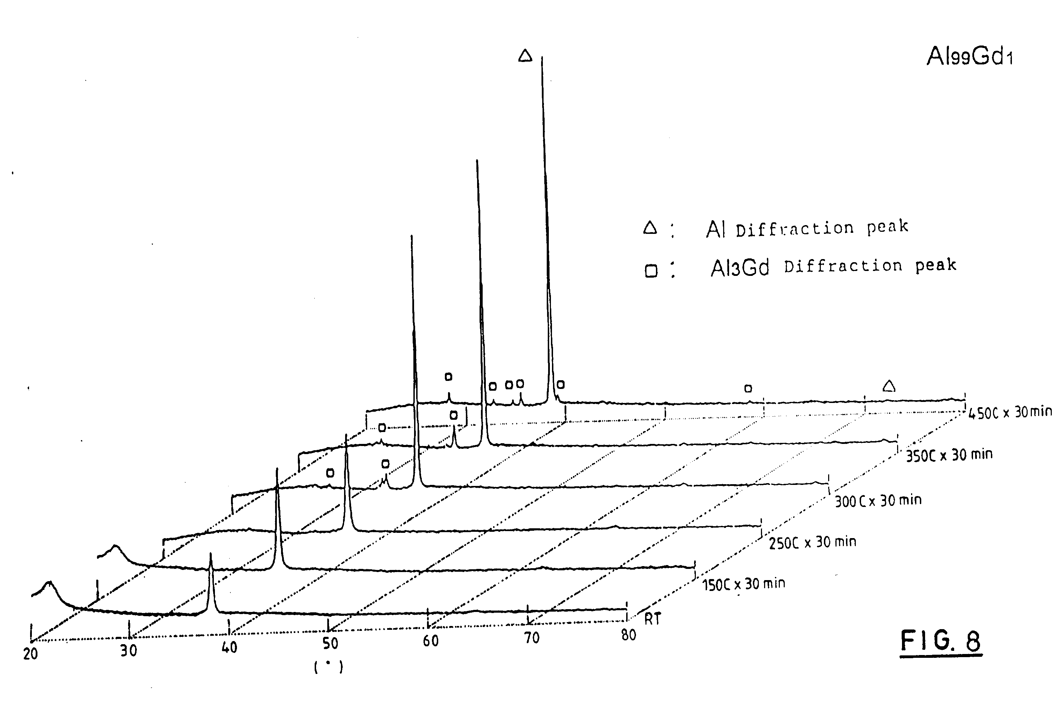

Figures 7 and 8 show X-ray diffraction charts of the material whose composition is Al₉₉Y₁ and Al₉₉Gd₁, respectively. The appearance of peaks (□), which were not present before heat treatment, is considered to correspond to the precipitation of intermetallic compounds. The precipitation of the intermetallic compound is significant from a temperature between 300 and 350°C. As Figure 6 shows, the decrease in electric resistance also becomes significant at this range of temperature. It is thought that the conductor line material produced according to the present invention contributes to the improvement of properties partly as a result of the precipitation of the intermetallic compound. It has been known that the occurrence of hillocks tends to decrease when an intermetallic compound of Al with any element is precipitated. However, the addition of any known element does not decrease the occurrence of hillocks as dramatically as the addition of rare-earth elements. In this aspect, the mechanism of hillock prevention is considered to result not only from the deposition of intermetallic compounds, but also from some unknown mechanism based on the inherent nature of rare-earth elements.

### Example 3

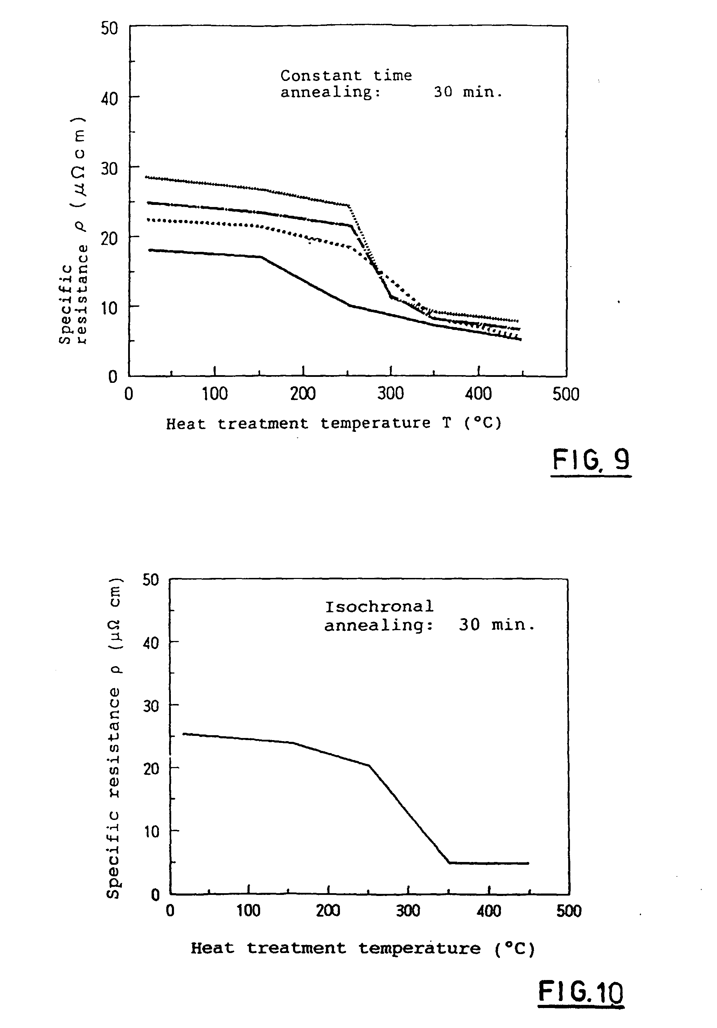

Thin films of Al alloys of a thickness of about 300 nm were prepared by vapour deposition and sputtering using composite targets made of alloys formed by mixing Al and an element selected from a group consisting of Pr, Sm, Er, and Ho so that the desired film composition was obtained. Table 3 shows the specific resistance and the occurrence of hillocks of Al alloy films after heat treatment in vacuum at 350°C for one hour. For comparison, the results of thin films consisting of Al element alone and typical alloy films consisting of Al and the above rare-earth elements in a total amount more than 3.0 atomic percent and less than 0.5 atomic percent. Figure 9 shows the change in the specific resistance of AlSm, AlHo AlPr, and AlEr alloy films during heat treatment in vacuum at various temperatures. In Figure 9, the uppermost curve represents Al₉₉Sm₁, followed by A1₉₉Pr₁ and A1₉₉Ho₁, and the lowermost curve represents Al₉₉Er₁.

**TABLE 3**

| | **Composition** | **Specific reisitance (µΩ·cm)** | **Occurrence of hillocks** |
|---|---|---|---|
| Embodiment | Al98.5Ho1.5 | 5.6 | none |
| Embodiment | Al98Pr2 | 6.2 | none |
| Embodiment | Al99.2Pr0.8 | 5.3 | none |
| Embodiment | Al98Er2 | 5.7 | none |
| Embodiment | Al99Er1 | 4.3 | none |
| Embodiment | Al99.2Ho0.5 | 5.4 | little |
| Embodiment | Al99.5Sm0.5 | 5.9 | little |
| Embodiment | Al97Sm3 | 4.8 | none |
| Embodiment | Al97.4Ho2.6 | 5.2 | none |
| Embodiment | Al97Er3 | 6.0 | none |
| Comparative Example | Al | 3.6 | Many |
| Comparative Example | Al99.7Pr0.3 | 5.5 | Many |
| Comparative Example | Al99.6Er0.4 | 4.0 | Many |
| Comparative Example | Al96.5Er3.5 | 7.2 | none |
| Comparative Example | Al96.5Pr3.5 | 7.2 | none |
| Comparative Example | Al96.2Sm3 | 7.4 | none |

As Table 3 shows, the thin film comprising an alloy of Al and rare-earth elements according to the present invention has a high thermal stability, fewer defects, and an extremely low electric resistance, which is most suitable for an electrode conductor line material for liquid crystal display devices TFT. Table 3 also shows that an excellent electrode material with fewer defects and a low electric resistance is obtained when the amount of the rare-earth elements added is 2 atomic percent or less. However, if the amount is smaller than 0.5 atomic percent, the occurrence of hillocks or pinholes increases significantly, and if the amount is larger than 3.0 atomic percent, electric resistance increase significantly. The effect of heat treatment temperature is almost the same as that in Example 2. That is, electric resistance begins to decrease from a temperature of 250°C or above, and heat treatment at a temperature of 300°C or above is preferable.

There is no doubt that microscopic internal changes, i.e. the precipitation of an intermetallic compound, contribute to the observed decrease in the occurrence of hillocks. It has been known that the occurrence of hillocks tends to decrease when an intermetallic compound of Al with any element is precipitated. However, the addition of any known element does not decrease the occurrence of hillocks as dramatically as the addition of rare-earth elements. In this aspect, the mechanism of hillock prevention is considered to result not only by the precipitation of intermetallic compounds, but also by some unknown mechanism based on the inherent nature of rare-earth metal elements. It is also possible to add elements studied for the same type of conductor line materials, such as Cr, Ti, Mo, W, Si, and Cu, to the extent that these elements do not affect the electrical properties and the occurrence of hillocks. This may be achieved when the total amount of these elements does not exceed 0.1 percent.

### Example 4

Thin films of Al alloys of about 400 nm in thickness were formed on a glass substrate by adding at least one element selected from a group consisting of Y, La, Pr, Nd, Gd, and Dy to Al so that desired film composition was obtained. The film was formed by vapour deposition and sputtering using composite targets comprising the chip of the above-mentioned elements formed on an alloy of desired film composition and on an Al plate. The glass substrate was made of glass 7059 and was 130 mm square in area.

Then the surface of the film was anodically oxidized in a solution prepared by mixing 3.68 percent-by-weight tartaric acid and ethylene glycol in the ratio 1:1, at a solution temperature of 5°C, a voltage of 150 V, and a current density of 1 m A/cm². The thickness of the anodic oxide film was about 200 nm.

Table 4 shows the specific resistance of two-layer films of Al alloy thin film (about 200 nm in thickness)/Al alloy anodic oxide film (about 200 nm in thickness), dielectric strength of anodic oxide films, and the number of hillocks after vacuum heat treatment at 350°C for one hour. For comparison, the results of two-layer film consisting of Al element alone thin film (200 nm thick)/Al anodic oxide film (200 nm thick) are also shown.

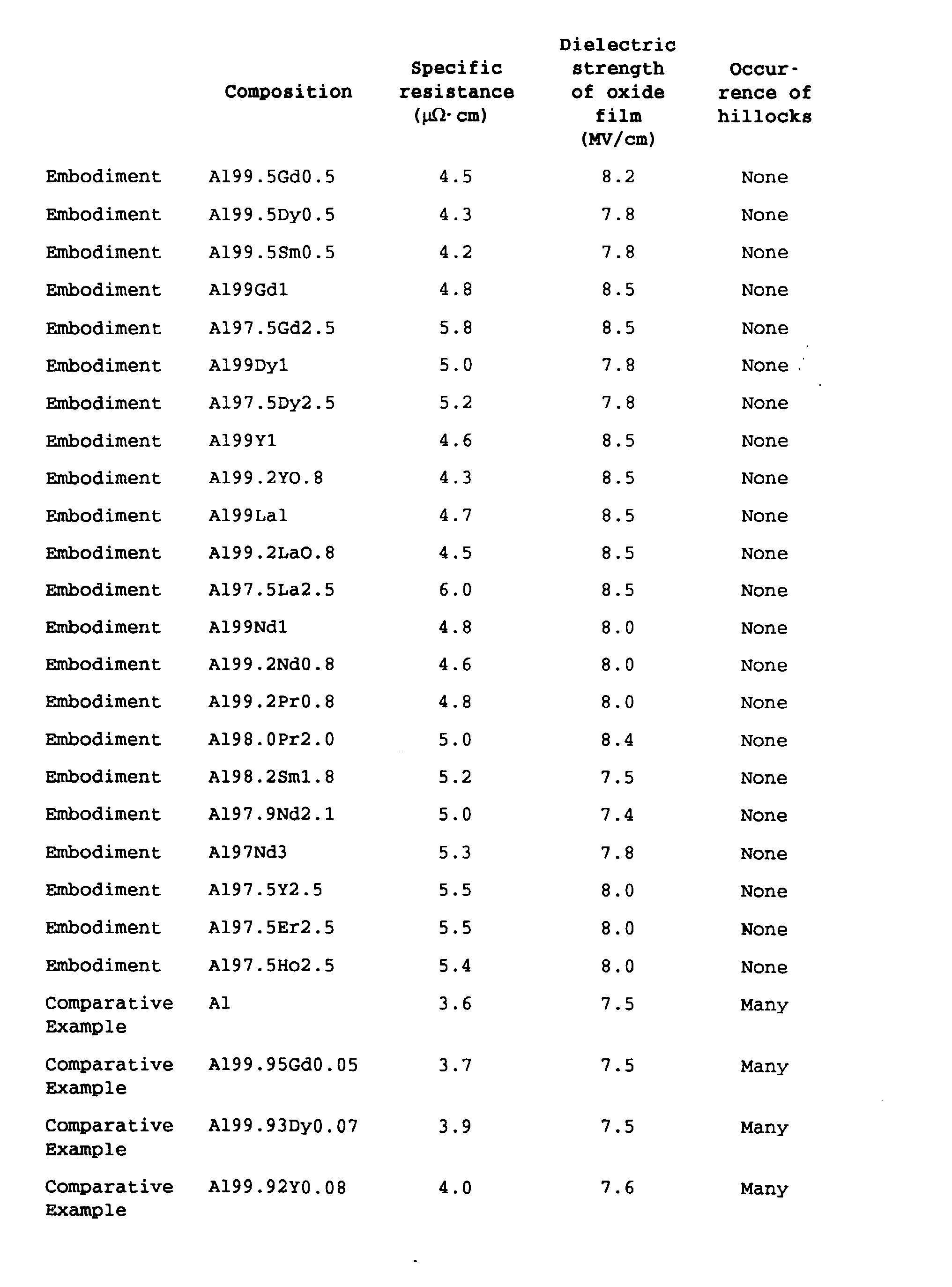

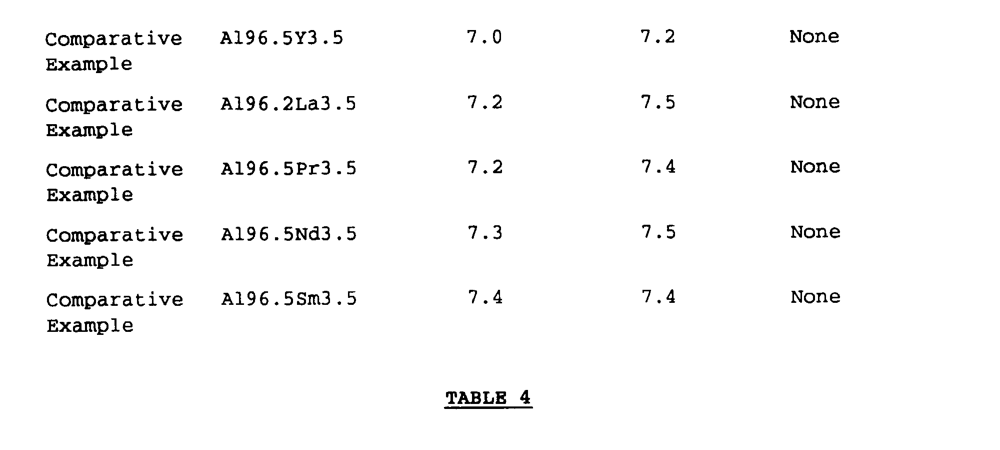

As Table 4 shows, the two-layer films of the present invention have high heat stability, few defects, high reliability, and an extremely low resistance, and are most suitable for the TFT electrode conductor line material for liquid-crystal display device. The cross section of the TFT including the anodic oxide film is exactly the same as the one shown in Figure 2. However, compared with the method of prior art which requires several CVD processes in order to form an insulating film with high dielectric strength, the present method forms anodic oxide film 21 with high dielectric strength by applying anodic oxidation directly to the gate electrode 20. This method significantly reduces process costs because insulating oxide film can be formed with less processes than conventional TFT structure and the conductor film is formed by using inexpensive Al alloy targets.

Dependency of dielectric strength on the thickness of film for some typical alloys shown in Table 4 was examined. Table 5 shows the results.

**TABLE 5**

| | **Composition** | **Thickness (nm)** | **Dielectric strength of oxide film (MV/cm)** | **Occurence of hillocks** |
|---|---|---|---|---|
| Comparative example | Al99.5Dy0.5 | 50 | 4.5 | None |
| Embodiment | Al99.5Dy0.5 | 100 | 7.5 | None |
| Embodiment | Al99.5Dy0.5 | 200 | 7.8 | None |
| Embodiment | Al99.5Dy0.5 | 360 | 7.9 | None |
| Comparative example | Al99.5Dy0.5 | 500 | 8.2 | None** |
| Comparative example | Al99.5Sm0.5 | 50 | 4.9 | None |
| Embodiment | Al99.5Sm0.5 | 100 | 7.8 | None |
| Embodiment | Al99.5Sm0.5 | 360 | 7.7 | None |
| Comparative example | Al99.5Sm0.5 | 500 | 7.8 | None** |
| Comparative example | Al99Gd1 | 50 | 5.6 | None |
| Embodiment | Al99Gd1 | 100 | 7.7 | None |
| Embodiment | Al99Gd1 | 360 | 7.7 | None |
| Comparative example | Al99Gd1 | 500 | 7.8 | None** |

| | | | | |
|---|---|---|---|---|
| (** indicates that dielectric breakdown occured.) | | | | |

Similar dependency on film thickness can be seen when other elements are added.

### Example 5

Thin films of Al alloys of a thickness of about 300 nm were prepared by vapour deposition and sputtering using composite targets made of alloys formed by mixing Al and Nb so that the desired film composition was obtained, and of Al plates on which Nb chips were provided. Table 6 shows the specific resistance of typical Al-Nb alloys after heat treatment in vacuum at 350°C for one hour, the density of the number of hillocks (8 µm W x 1 mm L), and breakdown voltage of anodically oxidized films of a thickness of 200 nm. For comparison, the results of thin films consisting of Al element alone and alloy films consisting of Al and additive elements in a total amount more than 2 atomic perce nt and less than 0.5 atomic percent.

**Table 6**

| **Composition** | **Specific resistance (Ω·cm)** | **Occurrence of hillocks** | **Breakdown voltage (MV/cm)** |
|---|---|---|---|
| Comparative example | | | |
| Al | 3.6 | 300 | 7.8 |
| Example | | | |
| Al98Nb2 | 6.2 | 10 | 7.7 |
| Al98.5Nb1.5 | 5.7 | 15 | 7.8 |
| Al99Nb1 | 5.6 | 20 | 7.8 |
| Comparative example | | | |
| Al97.5Nb2.5 | 15.0 | 7 | 7.0 |
| Al99.7Nb0.3 | 5.3 | 200 | 7.6 |

As Table 6 shows, good results are obtained when the concentration of Nb is between 0.5 and 2.0 atomic percent. The addition of Nb in this range lowers the good breakdown voltage of pure Al very little. If the concentration of Nb is as high as 2.5 atomic percent, the alloy is difficult to use as a conductor line material due to a high specific resistance, and the tendency of decrease in breakdown voltage is found. If the concentration of Nb is less than 0.5 atomic percent, the occurrence of hillocks is not improved.

Figure 10 shows the change in specific resistance of a typical alloy film of Al containing 1 atomic percent Nb after heat treatment in vacuum at 350°C. It is seen that heat treatment temperature must be at least 250°C, and preferably, 350°C or above. The disadvantage of heat treatment at high temperatures is the same as in previous examples.

Although the conductor line material has been described as a material for conductor line within a liquid crystal display device, this is only for the illustrative purpose, and it may be used in other applications which have similar requirements of (1) low electric resistance, and (2) free of defects such as hillocks caused by high temperature. The conductor line material is particularly suitable for applications which require the insulation of conductor line. Therefore, it is applicable to the conductor line material for semiconductor devices. It is also effective for achieving the object of the present invention to add elements studied for the same type of conductor line materials, such as Cr, Ti, Mo, W, Si, and Cu, to the extent that these elements do not affect the electrical properties and the occurrence of hillocks. The object of the present invention may be achieved when the total amount of these elements does not exceed 0.1 percent.

The present invention provides a conductor line material which has an extremely low electric resistance such as 10 µΩ·cm or less, and in preferred embodiments, about 5 µΩ·cm, causes no defect such as hillocks and pinholes even at high temperatures, and easily forms strong insulation films by anodic oxidation.

## Claims

1. A conductor line material substantially comprising Al and characterised in that the material comprises at least one element selected from a group consisting of rare-earth elements, the total quantity of said rare-earth elements being less than 3.0 atomic percent, and in that said conductor line material is formed by heat-treatment at a temperature between 250 and 450°C.

2. A conductor line material as claimed in claim 1 whose composition formula is substantially expressed by AlₓM₁₋ₓ, where M represents at least one element selected from a group consisting of rare-earth elements and x is between 98 and 99.5 atomic percent, a part of said rare-earth elements being substituted by at least one element selected from a group consisting of Nb, Zr, and Ta.

3. A conductor line material as claimed in claim 1 comprising an alloy whose composition formula is substantially expressed by Alₓ(M_{y}N_{1-y})₁₋ₓ, where M represents at least one element selected from a group consisting of rare-earth elements, N represents at least one element selected from a group consisting of Nb, Zr, and Ta, x is between 98 and 99.5 atomic percent, and y is a number between 0.1 and 0.9.

4. A conductor line material as claimed in claim 2 or claim 3 wherein an intermetallic compound of Al with said element represented by M or N is precipitated in the matrix by the heat treatment and the electric resistance of said alloy is 10 µΩ·cm or less.

5. A conductor line material as claimed in claim 1 wherein said rare-earth elements are one or more elements selected from a group consisting of Y, La, Pr, Nd, Sm, Gd, Dy, Ho, and Er, the total quantity of said rare-earth elements being between 0.1 and 3.0 atomic percent

6. A conductor line material as claimed in claim 5 wherein said rare-earth elements comprise one or more rare-earth elements selected from a group consisting of Y, La, Nd, Gd, and Dy, the total quantity of said rare-earth elements being between 0.1 and 3.0 atomic percent.

7. A conductor line material as claimed in claim 5 wherein said rare-earth elements comprise one or more rare-earth elements, said rare-earth elements being one or more elements selected from a group consisting of Pr, Sm, Ho, and Er, the total quantity of said rare-earth elements being between 0.5 and 3.0 atomic percent.

8. A conductor line material as claimed in any of claims 5 to 7 wherein an intermetallic compound of Al and said rare-earth elements is precipitated in the matrix by subsequent heat treatment, and the electric resistance thereof is 10 µΩ·cm or below.

9. A conductor line material comprising an alloy of Al and 0.5 - 2.0 atomic percent of Nb, which is heat-treated at a temperature between 250 and 450°C.

10. A conductor line material as claimed in claim 9 wherein an intermetallic compound of Al with Nb is precipitated in the matrix to adjust the electric resistance of said alloy to 10 µΩ·cm or less.

11. A liquid crystal display device comprising at least one of the conductor line materials as claimed in any of claims 1 to 10.

12. A method of making a metal conductor line layer comprising the step of providing a conductor line material comprising Al and at least one element selected from a group consisting of rare-earth elements, the total quantity of said rare-earth elements being less than 3.0 atomic percent, and heat-treating said conductor line material at a temperature between 250 and 450°C.

13. A method as claimed in claim 12 wherein the conductor line material has a composition formula substantially expressed by AlₓM₁₋ₓ, where M represents at least one element selected from a group consisting of rare-earth elements and x is between 98 and 99.5 atomic percent, a part of said rare-earth elements being substituted by at least one element selected from a group consisting of Nb, Zr, and Ta.

14. A method as claimed in claim 12 wherein the conductor line material has a composition formula substantially expressed by Alₓ(M_{y}N_{1-y})₁₋ₓ, where M represents at least one element selected from a group consisting of rare-earth elements, N represents at least one element selected from a group consisting of Nb, Zr, and Ta, x is between 98 and 99.5 atomic percent, and y is a number between 0.1 and 0.9.

15. A method as claimed in claim 13 or claim 14 wherein an intermetallic compound of Al with said element represented by M or N is precipitated in the matrix by the heat treatment and the electric resistance of said alloy is 10 µΩ·cm or less.

16. A method as claimed in claim 12 wherein said rare-earth elements are one or more elements selected from a group consisting of Y, La, Pr, Nd, Sm, Gd, Dy, Ho, and Er, the total quantity of said rare-earth elements being between 0.1 and 3.0 atomic percent.

17. A method as claimed in claim 16 wherein said rare-earth elements comprise one or more rare-earth elements selected from a group consisting of Y, La, Nd, Gd, and Dy, the total quantity of said rare-earth elements being between 0.1 and 2.5 atomic percent.

18. A method as claimed in claim 16 wherein said rare-earth elements comprise one or more rare-earth elements, said rare-earth elements being one or more elements selected from a group consisting of Pr, Sm, Ho, and Er, the total quantity of said rare-earth elements being between 0.5 and 2.0 atomic percent.

19. A method as claimed in any of claims 16 to 18 wherein an intermetallic compound of Al and said rare-earth elements is precipitated in the matrix by subsequent heat treatment, and the electric resistance thereof is 10 µΩ·cm or below.

20. A method of making a metal conductor line layer comprising the step of providing a conductor line material comprising an alloy of Al and 0.5 - 2.0 atomic percent of Nb, and heat-treating said conductor line material at a temperature between 250 and 450°C.

21. A method for forming a metal conductor line layer as claimed in any of claims 16 to 19, wherein at least a portion of said metal conductor line is subjected to anodic oxidation, prior to said heat treatment.

22. A method for forming a metal conductor line layer as claimed in any of claims 13 to 15, wherein at least a portion of said metal conductor line is subjected to anodic oxidation, after said heat treatment.

23. A method for forming a metal conductor line layer as claimed in claim 22, wherein the decrease in the breakdown voltage of the insulation film formed by said anodic oxidation from the breakdown voltage of pure Al is 15 percent or less.

24. A metal conductor line layer including an anodically oxidised portion of a conductor line material as claimed in any of claims 1 to 10.

25. A metal conductor line layer as claimed in claim 24 wherein the thickness of the film formed by applying said anodic oxidisation is between 100 nm and 400 nm.
